# EUROPÄISCHE PATENTSCHRIFT

(11) **EP 1 126 470 B1**
(45) Veröffentlichungstag und Bekanntmachung des Hinweises auf die Patenterteilung: **28.11.2007**
(21) Anmeldenummer: 01100917.2
(22) Anmeldetag: 16.01.2001
(51) Int. Cl.: G11C 11/22

(54) **Integrierter Halbleiterspeicher mit Speicherzellen mit ferroelektrischem Speichereffekt**
Integrated semiconductor memory with memory cells having ferroelectric memory effect
Mémoire intégrée à semiconducteurs avec des cellules de mémoire ayant un effet de mémorisation ferroélectrique

(30) Priorität: 09.02.2000 DE 10005619
(43) Veröffentlichungstag der Anmeldung: 22.08.2001
(73) Patentinhaber: Qimonda AG, 81739 München (DE)
(72) Erfinder: Esterl, Robert, 81827 München (DE); Hönigschmid, Heinz, East Fishkill, NY 12524 (US); Kandolf, Helmut, 81669 München (DE); Röhr, Thomas, Dr., 85609 Aschheim (DE)
(74) Vertreter: Epping - Hermann - Fischer

(56) Entgegenhaltungen:
- EP-A- 0 709 851
- EP-A- 0 994 486
- DE-A- 19 832 994
- US-A- 5 862 089
- US-A- 5 892 706
- HIROKI FUJISAWA ET AL: "THE CHARGE-SHARE MODIFIED PRECHARGE-LEVEL(CSM) ARCHITECTURE FOR HIGH-SPEED AND LOW-POWER FERROELECTRIC MEMORY" 1996 SYMPOSIUM ON VLSI CIRCUITS. DIGEST OF TECHNICAL PAPERS. HONOLULU, JUNE 13 - 15, 1996, SYMPOSIUM ON VLSI CIRCUITS, NEW YORK, IEEE, US, Bd. SYMP. 10, 13. Juni 1996 (1996-06-13), Seiten 50-51, XP000639013 ISBN: 0-7803-3340-3

## Beschreibung

Die vorliegende Erfindung betrifft einen integrierten Halbleiterspeicher mit Speicherzellen mit ferroelektrischem Speichereffekt, mit einem Speicherzellenfeld, das Zeilenleitungen zur Auswahl von Speicherzellen und Spaltenleitungen zum Auslesen oder Schreiben von Datensignalen der Speicherzellen aufweist, bei dem die Speicherzellen jeweils zwischen eine der Spaltenleitungen und eine Ladeleitung geschaltet sind, bei dem die Spaltenleitung an einen Leseverstärker angeschlossen ist und die Ladeleitung mit einer Treiberschaltung verbunden ist, durch die die Ladeleitung an einem vorgegebenen Potential anliegt, und bei dem die Spaltenleitung und die Ladeleitung jeweils eine aktive und inaktive Betriebsart aufweisen.

Integrierte Halbleiterspeicher mit sogenannten FeRAM-Speicherzellen, die einen ferroelektrischen Speichereffekt aufweisen, sind oftmals ähnlich aufgebaut wie beispielsweise DRAM-Speicher. Dort sind die Speicherzellen üblicherweise in einem matrixförmigen Speicherzellenfeld zu Einheiten von Spaltenleitungen und Zeilenleitungen zusammengefaßt. Die Spaltenleitungen sind dabei im allgemeinen an einen Leseverstärker angeschlossen, an dem ein auszulesendes und verstärktes Datensignal abgreifbar ist.

In Speicherzellen mit ferroelektrischem Speichereffekt werden Datensignale bekanntlich in Form von unterscheidbaren Polarisationszuständen des Materials in der Speicherzelle gespeichert. Im Betrieb des Halbleiterspeichers weisen die Speicherzellen im allgemeinen ein kapazitives Verhalten auf. Halbleiterspeicher mit derartigen Speicherzellen sind beispielsweise als sogenannte FeRAMs bekannt. Die Speicherzellen sind dabei üblicherweise zwischen eine der Spaltenleitungen und eine Ladeleitung, auch als sogenannte "Plate" bezeichnet, geschaltet. Diese Ladeleitung ist meist mit einer Treiberschaltung verbunden, durch die die Ladeleitung an einem vorgegebenen Potential anliegt.

Im Betrieb des Halbleiterspeichers weisen die Spaltenleitungen und die Ladeleitungen des Speichers jeweils eine aktive und inaktive Betriebsart auf. In der aktiven Betriebsart, in der beispielsweise der Inhalt einer Speicherzelle ausgelesen wird, ist die entsprechende Spaltenleitung mit einem Leseverstärker verbunden und die Ladeleitung liegt an einem vorgegebenen Potential an. In der inaktiven Betriebsart sind die entsprechenden Spaltenleitungen und die Ladeleitungen im allgemeinen mit einem Anschluß für ein gemeinsames Versorgungspotential verbunden.

Dies ist erforderlich, um eine unbeabsichtigte Veränderung des Inhalts einer Speicherzelle beispielsweise durch Störspannungen zu vermeiden. Solche Störspannungen entstehen beispielsweise durch Einkopplung eines Signals von einer aktiven Zeilenleitung auf eine nicht aktive Ladeleitung. Bei einer aktiven Zeilenleitung ist der Auswahltransistor zwischen der Speicherzelle und der betreffenden Spaltenleitung im leitenden Zustand. Insbesondere in diesem Betriebszustand ist es wesentlich, daß eine nicht aktive Spaltenleitung und eine nicht aktive Ladeleitung ein gleiches Potential aufweisen, damit die beiden Pole der angeschlossenen Speicherzelle an einem gleichen Potential anliegen.

Die Spaltenleitungen und Ladeleitungen, die sich in einer inaktiven Betriebsart befinden, werden häufig an einem gemeinsamen Spannungsnetz angeschlossen. Ein solches Spannungsnetz weist im allgemeinen vergleichsweise große Leitungskapazitäten und Leitungswiderstände auf, verursacht durch relativ große Abmessungen und Leitungslängen. Entstehen beispielsweise an einer inaktiven Spaltenleitung entlang einer aktiven Zeilenleitung Störspannungen zum Beispiel durch Einkopplung eines Signals, so ist es möglich, daß unerwünschte Potentialdifferenzen zwischen dieser Spaltenleitung und der Ladeleitung einer angeschlossenen Speicherzelle auftreten. Dies ist insbesondere dann der Fall, wenn die Anschlüsse der Spaltenleitung und der Ladeleitung an das Spannungsnetz für das gemeinsame Versorgungspotential räumlich getrennt sind, das heißt beispielsweise in unterschiedlichen Schaltungsteilen des Halbleiterspeichers angeschlossen sind. Durch vergleichsweise große Leitungskapazitäten und Leitungswiderstände des Spannungsnetzes wird ein notwendiger Potentialausgleich zwischen diesen Leitungen zeitlich verzögert. Somit kann eine kurzzeitige Potentialdifferenz an den Polen der Speicherzellen, die entlang einer aktiven Zeilenleitung angeordnet sind, entstehen, die den Inhalt der Speicherzellen unbeabsichtigt verändern kann.

In EP 0 994 486 wird ein integrierter Halbleiterspeicher mit ferroelektrischen Speicherzellen, die innerhalb eines Speicherzellenfeldes jeweils zwischen einer Bit- und einer Ladeleitung angeordnet sind, beschrieben. Wenn insbesondere beim Einschalten bzw. beim Hochfahren eines derart aufgebauten integrierten Halbleiterspeichers aus dem Ruhezustand ein Potentialunterschied zwischen der mit der Bitleitung verbundenen Elektrode und der mit der Ladeleitung verbundenen Elektrode eines Speicherkondensators einer Speicherzelle auftritt, so verändert sich im allgemeinen der innerhalb der ferroelektrischen Speicherzelle gespeicherte Polarisationszustand. Durch eine Verkleinerung der Hysteresekurve nimmt dabei die Polarisation des ferroelektrischen Materials zwischen den beiden Elektroden des Speicherkondensators der Speicherzelle so weit ab, daß die Speicherzelle nicht mehr zuverlässig auslesbar ist, bzw., daß in der Speicherzelle eine komplementäre Information abgespeichert wird. Deshalb wird vorgeschlagen, die Bit- und Ladeleitung insbesondere beim Einschalten bzw. Hochfahren des integrierten Halbleiterspeichers über mindestens einen Schalttransistor kurzzuschließen. Zusätzlich sorgt eine Potentialüberwachungseinheit dafür, daß die mit der Bitlei tung verbundene Elektrode und die mit der Ladeleitung verbundene Elektrode des Speicherkondensators das gleiche Potential annehmen.

In US 5,892,706 wird ein integrierter Halbleiterspeicher mit ferroelektrischen Speicherzellen beschrieben, bei dem eine Polarisationsumkehr des ferroelektrischen Materials infolge eines Einschalt-Reset-Signals vermieden wird. Das Einschalt-Reset-Signal wird im allgemeinen beim Einschalten eines FRAM (= Ferroelectric Random Access Memory)-Halbleiterspeichers dazu benutzt, einen unerwünschten Speicherzugriff zu verhindern. Um zu verhindern, daß der Signalimpuls des Einschalt-Reset-Signals eine Polarisationsumkehr und damit eine Verfälschung der in einer ferroelektrischen Speicherzelle gespeicherten Information bewirkt, ist eine Programmierschutzschaltung vorgesehen, bei der jeweils die an eine Speicherzelle angeschlossenen Bit- und Ladeleitungen über Schalttransistoren mit einem Bezugspotential verbindbar sind. Nach dem Einschalten des FRAM-Halbleiterspeichers werden die Schalttransistoren über das Einschalt-Reset-Signal leitend gesteuert und verhindern eine Polarisationsumkehr des Ferroelektrikums der Speicherzelle.

Hiroki Fujisawa et al. beschreiben in der Druckschrift "The Charge-Share Modified Precharge-Level (CSM) Architecture for High-Speed and Low-Power Ferroelectric Memory", 1996 Symposium on VLSI Circuits, Digest of Technical Papers, Honolulu, June 13-15, 1996, Symposium on VLSI Circuits, New York, IEEE, US, Bd. Symp. 10, 13. Juni 1996 (1996-06-13), Seiten 50-51, XP000639013, ISBN: 0-7803-3340-3 eine Architektur eines Halbleiterspeichers mit ferroelektrischen Speicherzellen, bei dem in einem Standby-Betrieb eine lokale Datenleitung und eine Hauptdatenleitung über Schalttransistoren auf einen gemeinsamen Spannungspegel aufgeladen werden. Wenn die lokale Datenleitung aktiviert wird, wird die auf einer parasitären Leitungskapazität der Hauptdatenleitung gespeicherte Ladung auf eine parasitäre Leitungskapazität der lokalen Datenleitung übertragen, so dass das Spannungspotential der lokalen Datenleitung ansteigt. Da die ausgewählte Datenleitung bei einem Zugriff nicht auf ein Versorgungspotential vorgeladen werden muss, lässt sich die Zugriffsgeschwindigkeit erhöhen.

Die Aufgabe der vorliegenden Erfindung ist es, einen integrierten Halbleiterspeicher der eingangs genannten Art anzugeben, bei dem außerhalb eines Speicherzugriffs eine unbeabsichtigte Veränderung des Speicherinhalts einer Speicherzelle infolge von Störspannungen vergleichsweise gering gehalten werden kann.

Die Aufgabe wird gelöst durch einen integrierten HalbleiterSpeicher nach Anspruch eines, der mit Speicherzellen mit ferroelektrischem Speichereffekt, und mit einem Speicherzellenfeld, das Zeilenleitungen zur Auswahl von Speicherzellen und Spaltenleitungen zum Auslesen oder Schreiben von Datensignalen der Speicherzellen aufweist, ausgestattet ist, bei dem die Speicherzellen jeweils zwischen eine der Spaltenleitungen und eine Ladeleitung geschaltet sind; bei dem die Spaltenleitung an einen Leseverstärker angeschlossen ist, an dem ein Ausgangssignal abgreifbar ist; bei dem die Ladeleitung mit einer Treiberschaltung verbunden ist, durch die die Ladeleitung an einem vorgegebenen Potential anlegbar ist; bei dem die Spaltenleitung und die Ladeleitung jeweils eine aktive oder eine inaktive Betriebsart aufweisen; bei dem in der aktiven Betriebsart die Spaltenleitung mit dem Leseverstärker verbunden und die Ladeleitung durch die Treiberschaltung an einem vorgegebenen Potential angeschlossen ist und bei dem in der inaktiven Betriebsart die Spaltenleitung vom Leseverstärker getrennt und gemeinsam mit der Ladeleitung mit einem Anschluß für ein gemeinsames Versorgungspotential verbunden ist. Der integrierte Halbleiterspeicher weist einen ersten Schalttransistor mit einem ersten und zweiten Anschluß auf. Einer der ersten und zweiten Anschlüsse des ersten Schalttransistors ist an die Spaltenleitung angeschlossen und ein anderer der ersten und zweiten Anschlüsse des ersten Schalttransistors ist an die Ladeleitung angeschlossen. Des weiteren weist der integrierte Halbleiterspeicher einen zweiten Schalttransistor mit einem ersten und zweiten Anschluß auf, wobei einer der ersten und zweiten Anschlüsse des zweiten Schalttransistors an die Ladeleitung angeschlossen und ein anderer der ersten und zweiten Anschlüsse des zweiten Schalttransistors an den Anschluß für das gemeinsames Versorgungspotential angeschlossen ist, wobei das gemeinsame Versorgungspotential ein Bezugspotential des integrierten Halbleiterspeichers ist. Darüber hinaus weist der integrierte Halbleiterspeicher eine Verarbeitungseinheit auf, wobei die Verarbeitungseinheit eingangsseitig mit einem Anschluß für ein Spaltenauswahlsignal und mit einem Anschluß für ein Zeilenauswahlsignal verbunden ist und die Verarbeitungseinheit ausgangsseitig mit einem Steueranschluß des ersten Schalttransistors und mit einem Steueranschluß des zweiten Schalttransistors verbunden ist.

Vorteilhafte Aus- und Weiterbildungen sind Gegenstand abhängiger Ansprüche.

Indem die Spaltenleitung und die Ladeleitung gemeinsam im Leseverstärker oder in der Treiberschaltung mit dem Anschluß für das gemeinsame Versorgungspotential verbunden sind, sind die entsprechende Spaltenleitung und Ladeleitung in relativer Nähe zueinander mit dem gemeinsamen Versorgungspotential verbunden. Dadurch werden vergleichsweise große Leitungskapazitäten und Leitungswiderstände, die durch vergleichsweise große Abmessungen und Leitungslängen des Spannungsnetzes verursacht werden, vermieden. Damit ist im Falle der Einkopplung von Störspannungen auf die betreffende Spaltenleitung und/oder Ladeleitung ein relativ schneller Potentialausgleich zwischen den Leitungen möglich. Es werden Potentialdifferenzen an den Polen einer Speicherzelle, die an einer inaktiven Spaltenleitung und einer aktiven Zeilenleitung angeschlossen ist, vergleichsweise gering gehalten. Damit wird eine unbeabsichtigte Veränderung des Speicherinhalts einer Speicherzelle infolge von Störspannungen vermieden.

Die Erfindung ist insbesondere anwendbar auf einen Halbleiterspeicher, der mit einem sogenannten Pulsed-Plate-Konzept (PPL-Konzept) betrieben wird. Beispielsweise weist bei einem Lesezyklus zum Auslesen eines Datensignals einer Speicherzelle die betreffende Spaltenleitung eine aktive Betriebsart auf. Die Spaltenleitung ist mit dem Leseverstärker verbunden, an dem das Datensignal abgreifbar ist. Die betreffende Ladeleitung liegt durch die Treiberschaltung an einem vorgegebenen Potential an. Dieses Potential entspricht beispielsweise dem positiven Versorgungspotential des Halbleiterspeichers. In der inaktiven Betriebsart ist die betreffende Spaltenleitung vom Leseverstärker getrennt und gemeinsam mit der Ladeleitung mit dem Anschluß für das gemeinsame Versorgungspotential verbunden. Dieses Versorgungspotential ist beispielsweise ein Bezugspotential des integrierten Halbleiterspeichers.

In einer Ausführungsform der Erfindung sind die Spaltenleitung und die Ladeleitung über ein erstes Schaltmittel miteinander verbunden, die Spaltenleitung oder die Ladeleitung ist über ein zweites Schaltmittel mit dem Anschluß für das Versorgungspotential verbunden. Dabei ist ein Steueranschluß des ersten Schaltmittels und ein Steueranschluß des zweiten Schaltmittels mit dem Anschluß für ein gemeinsames Steuersignal verbunden. Mit dieser Ausführungsform ist ein schneller Potentialausgleich bei einer Einkopplung von Störspannungen möglich, da die betreffende Spaltenleitung und die Ladeleitung über das erste Schaltmittel kurzgeschlossen sind. Über eine gemeinsame Ansteuerung des ersten Schaltmittels und des zweiten Schaltmittels sind beide Leitungen gemeinsam mit dem Anschluß für das Versorgungspotential verbunden.

In einer Weiterbildung der Erfindung weist der integrierte Halbleiterspeicher eine Verarbeitungseinheit auf, die eingangsseitig mit einem Anschluß für ein Spaltenauswahlsignal und mit einem Anschluß für ein Zeilenauswahlsignal verbunden ist. Ausgangsseitig ist die Verarbeitungseinheit mit dem Steueranschluß des ersten Schaltmittels und mit dem Steueranschluß des zweiten Schaltmittels verbunden. Das Spaltenauswahlsignal wird beispielsweise durch einen Spaltendecoder zur Auswahl einer der Spaltenleitungen erzeugt. Das Zeilenauswahlsignal wird beispielsweise durch einen Zeilendecoder erzeugt. Durch die Verknüpfung von Information aus der Spaltendekodierung und Zeilendekodierung werden floatende Zustände der Spaltenleitung in anderen Bereichen des Speicherzellenfeldes vermieden.

Das Speicherzellenfeld ist dabei üblicherweise in mehrere Blöcke unterteilt, die jeweils mehrere Zeilenleitungen umfassen. Während eines Speicherzugriffs sind dabei im allgemeinen nur die Speicherzellen innerhalb eines ausgewählten Blocks des Speicherzellenfeldes entlang der ausgewählten Spaltenleitung aktiviert. Durch die Ansteuerung der Verarbeitungseinheit mit dem Zeilenauswahlsignal ist es möglich, die ausgewählte Spaltenleitung in den übrigen inaktiven Bereichen des Speicherzellenfeldes mit dem Anschluß für das Versorgungspotential zu verbinden. In diesen Speicherbereichen ist damit ein floatender Zustand einer ausgewählten Spaltenleitung vermieden.

Die Erfindung wird im folgenden anhand der in der Zeichnung dargestellten Figuren näher erläutert. Es zeigen:
- Figur 1: eine schematische Darstellung eines Speicherzellenfeldes des Halbleiterspeichers,
- Figur 2: eine Ausführungsform des erfindungsgemäßen Halbleiterspeichers,
- Figur 3: eine schematische Darstellung eines Speicherzellenfeldes mit getrennten Potentialanschlüssen.

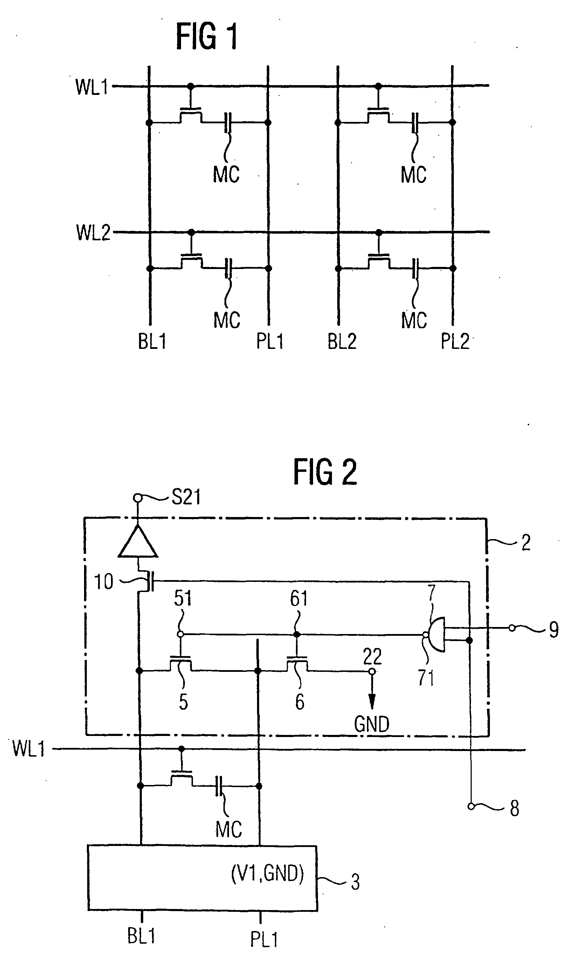

In Figur 1 ist ein Speicherzellenfeld eines Halbleiterspeichers gezeigt, das Speicherzellen MC mit ferroelektrischem Speichereffekt aufweist, die zu Einheiten von Spaltenleitungen BL1 und BL2 und Zeilenleitungen WL1 und WL2 zusammengefaßt sind. Die Speicherzellen MC sind dabei zwischen die Spaltenleitung BL1 und die Ladeleitung PL1 beziehungsweise zwischen die Spaltenleitung BL2 und Ladeleitung PL2 geschaltet. Die Ladeleitungen PL1 und PL2 werden üblicherweise als sogenannte "Plates" bezeichnet.

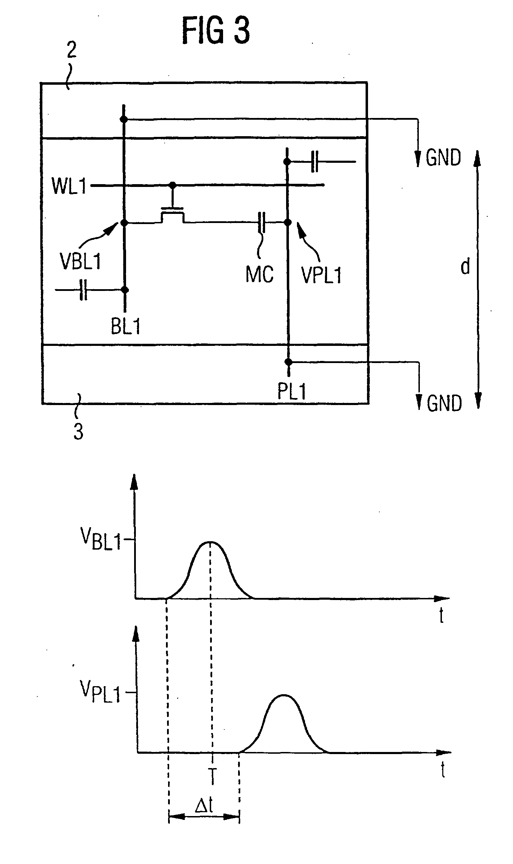

In Figur 3 ist eine schematisches Darstellung des Speicherzellenfeldes gezeigt, bei dem die Spaltenleitung BL1 und die Plate PL1 an getrennten Potentialanschlüssen für ein Versorgungspotential GND angeschlossen sind. Die Spaltenleitung BL1 und die Plate PL1 befinden sich in einer inaktiven Betriebsart. Die Spaltenleitung BL1 ist an einem Leseverstärker 2 angeschlossen und mit einem Anschluß für ein Bezugspotential GND verbunden. Die Plate PL1 ist an einer Treiberschaltung 3 angeschlossen, die zur Aufschaltung eines Potentials für die verschiedenen Betriebsarten der Plate PL1 dient. In der inaktiven Betriebsart ist die Plate PL1 ebenfalls mit einem Anschluß für das Bezugspotential GND verbunden. In Figur 3 wird angenommen, daß sich die Anschlüsse für das Bezugspotential GND der Spaltenleitung BL1 und der Plate PL1 in einem relativ großem Abstand zueinander befinden. Dieser Abstand d beträgt beispielsweise d = 0,5mm.

Im unteren Teil der Figur 3 ist ein Signaldiagramm gezeigt, das eine Störspannung V_{BL1} auf der Spaltenleitung BL1 darstellt, die beispielsweise durch Einkopplung auf die Spaltenleitung BL1 erzeugt wurde. Diese Störspannung V_{BL1} wird auf die Plate PL1 übertragen (V_{PL1}). Das Bezugsspannungsnetz repräsentiert dabei eine vergleichsweise große Leitungskapazität und einen vergleichsweise großen Leitungswiderstand. Die Spaltenleitung BL1 wird deshalb mit einer Zeitverzögerung Δt mit der Plate PL1 kurzgeschlossen. An den Polen der Speicherzelle MC, die an einer ausgewählten Zeilenleitung WL1 angeschlossen ist, tritt beispielsweise zum Zeitpunkt T eine Potentialdifferenz in Höhe der Störspannung V_{BL1} auf. Die Folge kann eine nicht beabsichtigte Veränderung des Speicherinhalts der Speicherzelle MC sein.

Figur 2 zeigt eine Ausführungsform des erfindungsgemäßen Halbleiterspeichers. Die Spaltenleitung BL1 ist an einen Leseverstärker 2 angeschlossen, an dem ein Ausgangssignal S21 abgreifbar ist. Die Plate PL1 ist mit einer Treiberschaltung 3 verbunden, die zur Aufschaltung beispielsweise eines positiven Versorgungspotentials V1 oder zur Aufschaltung eines Bezugspotentials GND dient.

Die Spaltenleitung BL1 und die Plate PL1 sind über ein Schaltmittel 5 miteinander verbunden. In diesem Ausführungsbeispiel ist die Plate PL1 über ein zweites Schaltmittel 6 mit dem Anschluß 22 für das Versorgungspotential GND verbunden. Die Schaltmittel 5 und 6 sind hier als Transistoren ausgeführt. Es ist dabei ebenso möglich, daß anstelle der Plate PL1 die Spaltenleitung BL1 über das Schaltmittel 6 mit dem Anschluß 22 für das Bezugspotential GND verbunden ist. Der Steueranschluß 51 des Schaltmittels 5 und der Steueranschluß 61 des Schaltmittels 6 sind mit dem Anschluß 71 für ein gemeinsames Steuersignal verbunden.

Der Halbleiterspeicher weist weiterhin eine Verarbeitungseinheit 7 auf, die eingangsseitig mit einem Anschluß 8 für ein Spaltenauswahlsignal und mit einem Anschluß 9 für ein Zeilenauswahlsignal verbunden ist. Ausgangsseitig ist die Verarbeitungseinheit 7 mit dem Steueranschluß 51 und dem Steueranschluß 61 verbunden. Die Verarbeitungseinheit 7 ist hier als NAND-Gatter ausgeführt.

Im folgenden wird die Funktionsweise des in Figur 2 dargestellten Halbleiterspeichers näher erläutert.

Der dargestellte Halbleiterspeicher arbeitet nach dem sogenannten Pulsed-Plate-Konzept (PPL-Konzept). Während eines Speicherzugriffs ist das Spaltenauswahlsignal am Anschluß 8 in einem aktiven Zustand (high-aktiv). Außerdem weist das Zeilenauswahlsignal am Anschluß 9 einen aktiven Zustand auf, so daß die leitende Verbindung über die Schaltmittel 5 und 6 unterbrochen ist. Die Zeilenleitung WL1 ist ausgewählt. Über den Transistor 10 ist die Spaltenleitung BL1 mit dem Leseverstärker 2 verbunden zum Auslesen und Verstärken des auszulesenden Datensignals der Speicherzelle MC. Gleichzeitig wird an die Plate PL1 die Spannung V1 durch die Treiberschaltung 3 angelegt.

Außerhalb eines Speicherzugriffs weist das Spaltenauswahlsignal am Anschluß 8 einen inaktiven Zustand auf. Dieser Zustand entspricht beispielsweise einem Bezugspotential, so daß der Transistor 10 im nicht leitenden Zustand ist. Über die Verarbeitungseinheit 7 werden die Spaltenleitung BL1 und die Plate PL1 mit dem Anschluß 22 für das Bezugspotential GND verbunden. Die Verarbeitungseinheit 7 stellt dabei sicher, daß nur bei einem aktiven Zustand des Spaltenauswahlsignals und bei einem aktiven Zustand des Zeilenauswahlsignals die kurzschließende Verbindung zwischen der Spaltenleitung BL1 und der Plate PL1 unterbrochen ist. In allen anderen Fällen sind die Spaltenleitung BL1 und die Plate PL1 kurzgeschlossen und mit dem Bezugspotential GND verbunden.

Das Zeilenauswahlsignal am Anschluß 9 ist beispielsweise ein Auswahlsignal zur Auswahl eines Speicherzellenblocks, der mehrere Zeilenleitungen unfaßt. Bei einem Speicherzugriff ist dabei im allgemeinen nur ein Speicherzellenblock aktiviert. Befindet sich die Spaltenleitung BL1 in der aktiven Betriebsart infolge eines aktiven Auswahlsignals am Anschluß 8, werden durch die Verknüpfung mit dem Zeilenauswahlsignal am Anschluß 9 floatende Zustände der aktiven Spaltenleitung BL1 in anderen inaktiven Speicherzellenblöcken vermieden.

In der Schaltungsanordnung nach der Figur 2 sind die Spaltenleitung BL1 und die Plate PL1 gemeinsam im Leseverstärker 2 mit dem Anschluß 22 für das Versorgungspotential GND verbunden. Es ist jedoch auch möglich, daß die Spaltenleitung BL1 und die Plate PL1 gemeinsam in der Treiberschaltung 3 mit dem Anschluß 22 für das Versorgungspotential GND verbunden sind. In beiden Fällen verringert sich die Größenordnung der kurzschließenden Verbindung zwischen den Leitungen beispielsweise zu d = 1µm bis 10µm.

## Patentansprüche

1. Integrierter Halbleiterspeicher
- mit Speicherzellen (MC) mit ferroelektrischem Speichereffekt,
- mit einem Speicherzellenfeld, das Zeilenleitungen (WL1, WL2) zur Auswahl von Speicherzellen (MC) und Spaltenleitungen (BL1, BL2) zum Auslesen oder Schreiben von Datensignalen der Speicherzellen aufweist,
- bei dem die Speicherzellen (MC) jeweils zwischen eine der Spaltenleitungen (BL1) und eine Ladeleitung (PL1) geschaltet sind,
- bei dem die Spaltenleitung (BL1) an einen Leseverstärker (2) angeschlossen ist, an dem ein Ausgangssignal (S21) abgreifbar ist,
- bei dem die Ladeleitung (PL1) mit einer Treiberschaltung (3) verbunden ist, durch die die Ladeleitung (PL1) an einem vorgegebenen Potential (V1, GND) anlegbar ist,
- bei dem die Spaltenleitung (BL1) und die Ladeleitung (PL1) jeweils eine aktive oder eine inaktive Betriebsart aufweisen,
- bei dem in der aktiven Betriebsart die Spaltenleitung (BL1) mit dem Leseverstärker (2) verbunden und die Ladeleitung durch die Treiberschaltung (3) an einem vorgegebenen Potential (V1) angeschlossen ist,
- bei dem in der inaktiven Betriebsart die Spaltenleitung (BL1) vom Leseverstärker getrennt und gemeinsam mit der Ladeleitung (PL1) mit einem Anschluß (22) für ein gemeinsames Versorgungspotential (GND) verbunden ist,
- mit einem ersten Schalttransistor (5) mit einem ersten und zweiten Anschluß,
- bei dem einer der ersten und zweiten Anschlüsse des ersten Schalttransistors (5) an die Spaltenleitung (BL1) angeschlossen und ein anderer der ersten und zweiten Anschlüsse des ersten Schalttransistors (5) an die Ladeleitung (PL1) angeschlossen ist,
**dadurch gekennzeichnet, daß**
- der integrierte Halbleiterspeicher einen zweiten Schalttransistor (6) mit einem ersten und zweiten Anschluß aufweist,
- wobei einer der ersten und zweiten Anschlüsse des zweiten Schalttransistors (6) an die Ladeleitung (PL1) angeschlossen und ein anderer der ersten und zweiten Anschlüsse des zweiten Schalttransistors (6) an den Anschluß (22) für das gemeinsame Versorgungspotential (GND) angeschlossen ist, wobei das gemeinsame Versorgungspotential ein Bezugspotential des integrierten Halbleiterspeichers ist,
- der integrierte Halbleiterspeicher eine Verarbeitungseinheit (7) aufweist,
- wobei die Verarbeitungseinheit (7) eingangsseitig mit einem Anschluß (8) für ein Spaltenauswahlsignal und mit einem Anschluß (9) für ein Zeilenauswahlsignal verbunden ist, und
- wobei die Verarbeitungseinheit (7) ausgangsseitig mit einem Steueranschluß (51) des ersten Schalttransistors (5) und mit einem Steueranschluß (61) des zweiten Schalttransistors (6) verbunden ist.

2. Integrierter Halbleiterspeicher nach Anspruch 1,
**dadurch gekennzeichnet, daß**
die Spaltenleitung (BL1) und die Ladeleitung (PL1) in der inaktiven Betriebsart gemeinsam in der Treiberschaltung (3) mit dem Anschluß (22) für das gemeinsame Versorgungspotential (GND) verbunden sind

3. Integrierter Halbleiterspeicher nach einem der Ansprüche 1 oder 2,
**dadurch gekennzeichnet, daß**
die Verarbeitungseinheit (7) den Steueranschluß (51) des ersten Schalttransistors (5) und den Steueranschluß (61) des zweiten Schalttransistors (6) derart ansteuert, dass bei einem aktiven Zustand des Spaltenauswahlsignals und bei einem aktiven Zustand des Zeilenauswahlsignals der erste Schalttransistor (5) gesperrt ist, so dass die Bitleitung (BL1) und die Ladeleitung (PL1) voneinander getrennt sind, und bei allen anderen Zuständen des Spaltenauswahlsignals und des Zeilenauswahlsignals der erste Schalttransistor (5) leitend gesteuert ist, so dass die Bitleitung (BL1) und die Ladeleitung (PL1) untereinander verbunden sind, und der zweite Schalttransistor (6) leitend gesteuert ist, so dass die Bitleitung (BL1) und die Ladeleitung (PL1) mit dem Anschluß (22) für das gemeinsame Versorgungspotential verbunden sind.

4. Integrierter Halbleiterspeicher nach einem der Ansprüche 1 bis 3,
**dadurch gekennzeichnet, daß**
die Verarbeitungseinheit (7) ein logisches NAND-Gatter enthält.

## Claims

1. Integrated semiconductor memory, comprising:
- memory cells (MC) with ferroelectric memory effect,
- a memory cell array which exhibits row lines (WL1, WL2) for selecting memory cells (MC) and column lines (BL1, BL2) for reading or writing data signals of the memory cells,
- the memory cells (MC) being in each case connected between one of the column lines (BL1) and a charge line (PL1),
- the column line (BL1) being connected to a read amplifier (2) at which an output signal (S21) can be picked up,
- the charge line (PL1) being connected to a driver circuit (3) by means of which the charge line (PL1) can be placed at a predetermined potential (V1, GND),
- the column line (BL1) and the charge line (PL1) in each case having an active mode or an inactive mode,
- wherein, in the active mode, the column line (BL1) is connected to the read amplifier (2) and the charge line is connected to a predetermined potential (V1) by the driver circuit (3),
- wherein, in the inactive mode, the column line (BL1) is separate from the read amplifier and, together with the charge line (PL1), is connected to a connection (22) for a common supply potential (GND),
- a first switching transistor (5) having a first and a second connection,
- one of the first and second connections of the first switching transistor (5) being connected to the column line (BL1) and another of the first and second connections of the first switching transistor (5) being connected to the charge line (PL1),
**characterized in that**
- the integrated semiconductor memory has a second switching transistor (6) having a first and a second connection,
- one of the first and second connections of the second switching transistor (6) being connected to the charge line (PL1) and another of the first and second connections of the second switching transistor (6) being connected to the connection (22) for the common supply potential (GND), the common supply potential being a reference potential of the integrated semiconductor memory,
- the integrated semiconductor memory comprising a processing unit (7),
- the input of the processing unit (7) being connected to a connection (8) for a column select signal and to a connection (9) for a row select signal, and
- the output of the processing unit (7) being connected to a control connection (51) of the first switching transistor (5) and to a control connection (61) of the second switching transistor (6).

2. Integrated semiconductor memory according to Claim 1,
**characterized in that**,
in the inactive mode, the column line (BL1) and the charge line (PL1) are jointly connected to the connection (22) for the common supply potential (GND) in the driver circuit (3).

3. Integrated semiconductor memory according to either of Claims 1 and 2,
**characterized in that**
the processing unit (7) drives the control connection (51) of the first switching transistor (5) and the control connection (61) of the second switching transistor (6) in such a manner that, in an active state of the column select signal and in an active state of the row select signal, the first switching transistor (5) is off, with the result that the bit line (BL1) and the charge line (PL1) are separate from one another, and, in all other states of the column select signal and of the row select signal, the first switching transistor (5) is turned on, with the result that the bit line (BL1) and the charge line (PL1) are connected to one another, and the second switching transistor (6) is turned on, with the result that the bit line (BL1) and the charge line (PL1) are connected to the connection (22) for the common supply potential.

4. Integrated semiconductor memory according to one of Claims 1 to 3, **characterized in that** the processing unit (7) contains a logic NAND gate.

## Revendications

1. Mémoire intégrée à semi-conducteur
- ayant des cellules (MC) de mémoire à effet de mémorisation ferroélectrique,
- ayant un champ de cellules de mémoire, qui a des conducteurs (WL1, WL2) de lignes pour la sélection de cellules (MC) de mémoire et des conducteurs (BL1, BL2) de colonnes pour la lecture ou l'écriture de signaux de données de cellules de mémoire,
- dans laquelle les cellules (MC) de mémoire sont montées respectivement entre l'un des conducteurs (BL1) de colonnes et un conducteur (PL1) de charge,
- dans laquelle le conducteur (BL1) de colonnes est raccordé à un amplificateur (2) de lecture sur lequel un signal (S21) de sortie peut être prélevé,
- dans laquelle le conducteur (PL1) de charge est relié à un circuit (3) d'attaque par lequel le conducteur (PL1) de charge peut être mis à un potentiel (V1, GND) prescrit,
- dans laquelle le conducteur (BL1) de colonnes et le conducteur (PL1) de charge ont respectivement un type de fonctionnement actif ou un type de fonctionnement inactif,
- dans laquelle, dans le type de fonctionnement actif, le conducteur (BL1) de colonnes est relié à l'amplificateur (2) de lecture et le conducteur de charge est raccordé par le circuit (3) d'attaque à un potentiel (V1) prescrit,
- dans laquelle, dans le type de fonctionnement inactif, le conducteur (BL1) de colonnes est séparé de l'amplificateur de lecture et est relié, en commun avec le conducteur (PL1) de charge, à une borne (22) pour un potentiel (GND) d'alimentation commun,
- ayant un premier transistor (5) de commutation ayant une première borne et une deuxième borne,
- dans laquelle l'une des première et deuxième bornes du premier transistor (5) de commutation est raccordée au conducteur (BL1) de colonnes et une autre des première et deuxième bornes du premier transistor (5) de commutation est raccordée au conducteur (PL1) de charge,
**caractérisée en ce que**
- la mémoire intégrée à semi-conducteur a un deuxième transistor (6) de commutation ayant une première borne et une deuxième borne,
- dans laquelle l'une des première et deuxième bornes du deuxième transistor (6) de commutation est raccordée au conducteur (PL1) de charge et une autre des première et deuxième bornes du deuxième transistor (6) de commutation est raccordée à la borne (22) pour le potentiel (GND) d'alimentation commun, le potentiel d'alimentation commun étant un potentiel de référence de la mémoire intégrée à semi-conducteur,
- la mémoire intégrée à semi-conducteur a une unité (7) de traitement,
- dans laquelle l'unité (7) de traitement est reliée, du côté entrée, à une borne (8) pour un signal de sélection de colonne et à une borne (9) pour un signal de sélection de ligne, et
- dans laquelle l'unité (7) de traitement est reliée, côté sortie, à une borne (51) de commande du premier transistor (5) de commutation et à une borne (61) de commande du deuxième transistor (6) de commutation.

2. Mémoire intégrée à semi-conducteur suivant la revendication 1,
**caractérisée en ce que**
le conducteur (BL1) de colonnes et le conducteur (PL1) de charge sont reliés, dans le type de fonctionnement inactif, en commun dans le circuit (3) d'attaque avec la borne (22) pour le potentiel (GND) d'alimentation commun.

3. Mémoire intégrée à semi-conducteur suivant l'une des revendications 1 ou 2,
**caractérisée en ce que**
l'unité (7) de traitement commande la borne (51) de commande du premier transistor (5) de commutation et la borne (61) de commande du deuxième transistor (6) de commutation de façon à ce que, dans un état actif du signal de sélection de colonne et dans un état actif du signal de sélection de ligne, le premier transistor (5) de commutation est bloqué, de sorte que le conducteur (BL1) de bits et le conducteur (PL1) de charge sont séparés l'un de l'autre, et dans tous les autres états du signal de sélection de colonne et du signal de sélection de ligne, le premier transistor (5) de commutation est commandé de manière à être passant, de sorte que le conducteur (BL1) de bits et le conducteur (PL1) de charge sont reliés entre eux, et le deuxième transistor (6) de commutation est commandé de manière à être passant, de sorte que le conducteur (BL1) de bits et le conducteur (PL1) de charge sont reliés à la borne (22) pour le potentiel d'alimentation commun.

4. Mémoire intégrée à semi-conducteur suivant l'une des revendications 1 à 3,
**caractérisée en ce que**
l'unité (7) de traitement comporte une porte NON ET logique.
